# EUROPEAN PATENT APPLICATION

(11) **EP 2 938 173 A1**
(43) Date of publication of application: **28.10.2015**
(21) Application number: 14305611.7
(22) Date of filing: 25.04.2014
(51) Int. Cl.: H05K 7/20

(54) **Electronics enclosure cooling**

(71) Applicant: ALCATEL LUCENT, 92100 Boulogne-Billancourt (FR)
(72) Inventor: Akalanne, Lucius, Swindon, Wiltshire SN5 7YT (GB); Kerslake, Simon, Swindon, Wiltshire SN5 7YT (GB); Martin, Adam, Swindon, Western Isles SN5 7DJ (GB)
(74) Representative: Lichota, Catherine Margaret Timmis

(57) **Abstract**

An electronics enclosure (201) comprising cooling apparatus (202). The cooling apparatus (202) comprises a heat transfer pipe (203) so located within the electronics enclosure (201) as to extend between a first opening (204) in a top surface (205) thereof and a second opening (206) in a second lower surface (207) thereof and to present first and second ends (208, 209) open to the atmosphere. The heat transfer pipe (203) comprises a wall (301) defining an interior flow passage therethrough between the first and second open ends (208, 209), a plurality of longitudinal interior fins (302) within the interior flow passage, and a plurality of exterior fins (303) along the wall (301). A heat transfer pipe (203) for use in cooling an electronics enclosure (201). A method of providing an electronics enclosure (201) with cooling apparatus (202).

## Description

### Field of the Invention

The present invention relates to electronics enclosure cooling, in particular to electronics enclosure cooling apparatus comprising a heat transfer pipe.

### Background of the Invention

A type of electronics enclosure is a remote radio head of a distributed base station. Remote radio head technology allows base station components to be distributed in multiple locations, enabling more flexible deployments by reducing real estate and space requirements. A remote radio head (RRH) contains radio frequency (RF) components in a relatively small single unit that can be deployed at a location remote from a main base band unit (BBU). The remote radio head can be mounted close to the antenna, using fibre optic links, to reduce feeder losses and to improve coverage. An outdoor remote radio head is typically mounted on a pole or on the roof or side of a building; however, a remote radio head could also be located indoors or within a confined space such as a tunnel or elevator shaft.

A problem exists in that waste heat trapped within the remote radio head can have a detrimental effect on the proper operation and reliability of the housed equipment. It is therefore desirable to inhibit rises in the internal temperature of the hermetically sealed remote radio head. However, there are many design factors that affect the potential suitability of any proposed cooling solution. For example, any cooling provision needs to be robust, and able to withstand different weather conditions and environments in which the electronics enclosure may be located, and needs to minimise any increase in the weight, overall size and the cost of the electronics enclosure.

It has been proposed previously to increase the provision of the external heat sink fins; however, an increase in fin density can decrease the efficiency of the external heat sink fins and an increase in the size of the external heat sink fins can result in an unacceptable increase in the overall dimensions and weight of the unit.

Another previous proposal has been to use electrically-powered fans; however, the associated use of additional power, the generation of acoustic noise and the risk of clogging are all undesirable. Yet another previous proposal is to use a known heat pipe; however, the risk of leakage is undesirable. Further, it is desirable to avoid added maintenance burden.

### Summary of the Invention

According to a first aspect there is provided an electronics enclosure comprising cooling apparatus, said cooling apparatus comprising: at least one heat transfer pipe, each said heat transfer pipe so located within the electronics enclosure as to extend between a first opening in a top surface of the electronics enclosure and a second opening in a second lower surface of the electronics enclosure, and to present first and second ends open to the atmosphere, and each said heat transfer pipe comprising a wall defining an interior flow passage therethrough between the first and second open ends, a plurality of longitudinal interior fins within said interior flow passage, and a plurality of exterior fins along said wall.

The second opening may be one of: a bottom surface of the electronics enclosure, a side surface of the electronics enclosure.

The first and second ends of said heat transfer pipe may be substantially flush with the outer surfaces of the electronic enclosure.

At least one connecting element is provided that connects between heat emitting equipment within the electronics enclosure and a heat transfer pipe of the cooling apparatus may be provided.

The electronics enclosure may be bracket mounted or ground mounted.

In an embodiment, the electronics enclosure is a remote radio head.

According to a second aspect there is provided a heat transfer pipe for use in cooling an electronics enclosure, said heat transfer pipe so installable within the electronics enclosure as to extend between a first opening in a top surface of the electronics enclosure and a second opening in a second lower surface the electronics enclosure, and each said heat transfer pipe comprising a wall defining an interior flow passage therethrough, a plurality of longitudinal interior fins within said interior flow passage, and a plurality of exterior fins along said wall.

The exterior fins of the heat transfer pipe may be radial fins or longitudinal fins.

The interior flow passage of the heat transfer pipe may be substantially linear or substantially curvilinear.

The heat transfer pipe may comprise a substantially circular cross-sectional shape or a substantially rectangular cross-sectional shape.

The internal fins of the heat transfer pipe may be arranged to divide the interior flow passage into a plurality of passageways.

The internal fins of the heat transfer pipe may be are carried on a structure that is removable from the interior flow passage.

The heat transfer pipe may be supported by an installation frame that is locatable within the electronics enclosure.

According to a third aspect there is provided a method of providing an electronics enclosure with cooling apparatus, comprising the steps of: a) receiving a heat transfer pipe comprising a wall defining an interior flow passage therethrough between first and second open ends, a plurality of longitudinal interior fins within said interior flow passage, and a plurality of exterior fins along said wall, and b) locating said received heat transfer pipe within said electronics enclosure such that said heat transfer pipe extends between a first opening in an upper surface of the electronics enclosure and a second opening in a second lower surface of the electronics enclosure, with upper and lower ends of the interior flow passage open to the atmosphere.

Different aspects and embodiments of the invention may be used separately or together.

Further particular and preferred aspects of the present invention are set out in the accompanying independent and dependent claims. Features of the dependent claims may be combined with the features of the independent claims as appropriate, and in combination other than those explicitly set out in the claims.

### Brief Description of the Drawings

The present invention will now be more particularly described, with reference to the accompanying drawings, in which:
Figure 1 shows a schematic of a prior art remote radio head (RRH);
Figure 2 shows a schematic of a remote radio head (RRH) provided with cooling apparatus according to the present invention;
Figure 3 shows features of a heat transfer pipe of cooling apparatus for use in cooling an electronics enclosure;
Figure 4 shows a further feature of cooling apparatus for use in cooling an electronics enclosure;
Figure 5 an alternative arrangement of heat transfer pipes installed for use in cooling an electronics enclosure;
Figure 6 shows features of an embodiment of a heat transfer pipe;
Figure 7 shows a heat transfer pipe comprising an alternative arrangement of exterior fins;
Figures 8 & 9 each show a heat transfer pipe comprising an alternative arrangement cross-sectional shape;
Figures 10 & 11 each show a heat transfer pipe comprising an alternative arrangement of internal fins;
Figure 12 shows examples of installation frames, each supporting at least one heat transfer pipe;
Figures 13 & 14 each shows an alternative relative arrangement of heat transfer pipe and external walling of an electronics enclosure;
Figures 15 & 16 show optional additional features of cooling apparatus for use in cooling an electronics enclosure according to the present invention;
Figures 17 & 18 show different methods of installation of an electronics enclosure in which the bottom surface thereof is exposed;
Figure 19 shows a schematic of a ground-mounted electronics enclosure provided with cooling apparatus according to the present invention; and
Figure 20 shows a heat transfer pipe comprising an alternative arrangement of interior flow passage.

### Description

Example embodiments are described below in sufficient detail to enable those of ordinary skill in the art to embody and implement the systems and processes herein described. It is important to understand that embodiments can be provided in many alternate forms and should not be construed as limited to the examples set forth herein. Elements of the example embodiments are consistently denoted by the same reference numerals throughout the drawings and detailed description where appropriate.

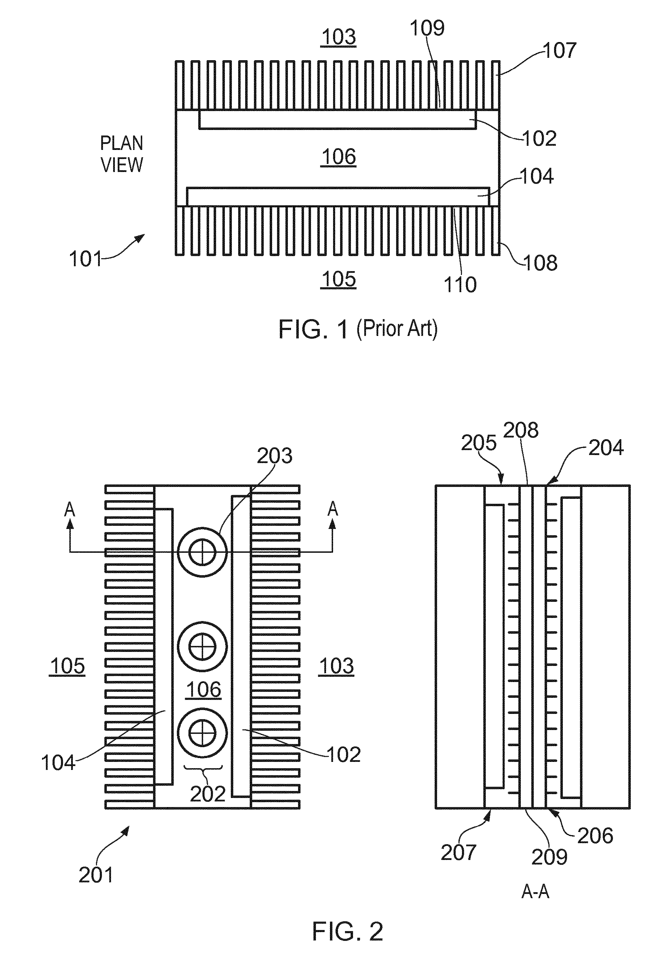

A schematic of a prior art electronics enclosure in the form of a remote radio head (RRH) 101 is shown in Figure 1. The substantially rectangular cuboid body of the remote radio head comprises a pair of half-shell elements, which when brought together with top and bottom weatherised seals, define a hermetically sealed internal chamber. The remote radio head 101 houses internally first equipment 102 towards one side 103 and second equipment 104 towards the other, opposite side 105, with an internal volume of waste space 106 between. A series of external heat sink fins 107, 108 is provided along the external surfaces 109, 110 of each side 103, 105 respectively to effect a degree of cooling. A problem exists in that waste heat trapped within the remote radio head 101 can have a detrimental effect on the proper operation and reliability of the housed equipment 102, 104. It is therefore desirable to provide the remote radio head 101 with improved cooling.

Figure 2 shows a schematic of an electronics enclosure 201 comprising cooling apparatus 202 according to the present invention. The electronics enclosure 201 of this Figure is a remote radio head similar to the remote radio head 101, in that it similarly houses first equipment 102 towards one side 103 and second equipment 104 towards the other, opposite side 105, with an internal volume of waste space 106 between. A series of external heat sink fins 107, 108 is provided along the external surfaces 109, 110 of each side 103, 105 respectively to effect a degree of cooling. The cooling apparatus 202 comprises at least one heat transfer pipe 203. In this example, the cooling apparatus 201 comprises a plurality of heat transfer pipes 203. In particular, in this example, the cooling apparatus 202 comprises three heat transfer pipes, but a fewer or a greater number of heat transfer pipes may be utilised.

Each heat transfer pipe 203 is so located within the electronics enclosure 201 as to extend between a first opening 204 in a top surface 205 of the electronics enclosure 201 and a second opening 206 in a second, lower surface 207 of the electronics enclosure 201, and to present first and second ends 208, 209 open to the atmosphere. In this embodiment, the second opening 206 is in a bottom surface of the electronics enclosure 201. In this embodiment also, the first and second ends 208, 209 of each heat transfer pipe 203 are substantially flush with the outer surfaces 205, 207 of the electronics enclosure 201.

It can be seen from this Figure that, in this embodiment, each heat transfer pipe 203 is disposed within the internal volume of waste space 106 inside the remote radio head 201, between the first equipment 102 and the second equipment 104. When installed for use, the remote radio head 301 is typically mounted at a site at which the remote radio head 301 is exposed to the elements, being subject at least to the circulation of air around the unit and typically also the general weather conditions in the immediate external environment.

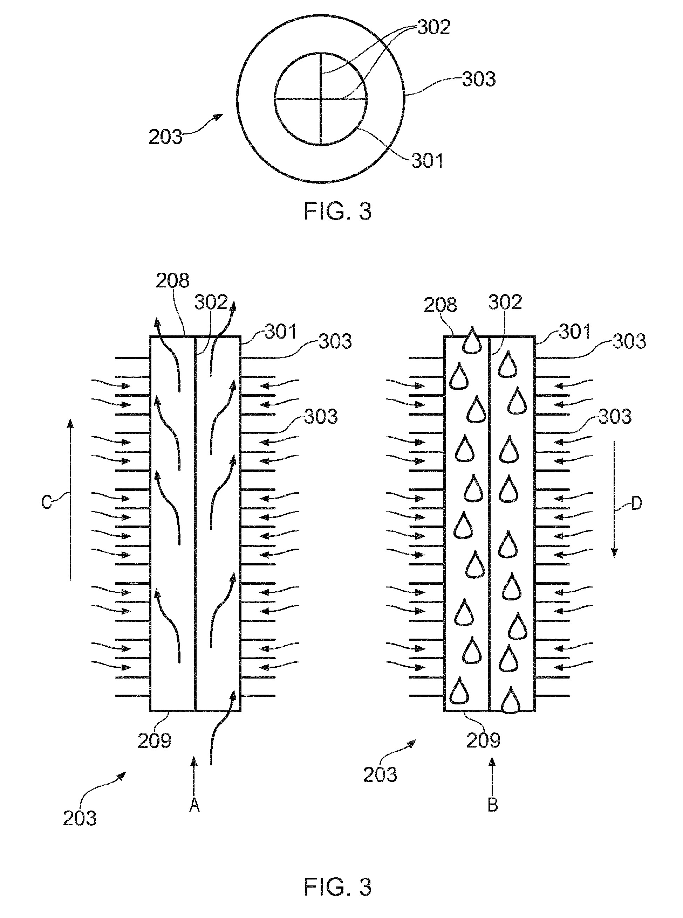

Heat transfer pipe 203 of cooling apparatus 202 is shown in further detail in Figure 3.

The heat transfer pipe 203 comprises a wall 301 defining an interior flow passage therethrough between the first and second open ends 208, 209, a plurality of longitudinal interior fins 302 within the interior flow passage, and a plurality of exterior fins 303 along the wall 301. In this illustrated embodiment, the exterior fins 303 are radial fins. The radial fins may be plate fins, or spiral or helical wrapped fins. Any suitable number of the longitudinal interior fins may be provided, which may vary between examples. Similarly, any suitable number of the radial exterior fins may be provided, which may vary between examples.

According to this illustrated embodiment, the interior flow passage of heat transfer pipe 203 comprises a substantially circular cross-sectional shape. The heat transfer pipe, and the interior flow passage, may each have any suitable cross-sectional shape, which may vary individually or together between examples. In this illustrated embodiment, the interior flow passage of heat transfer pipe 203 is substantially linear, so as to extend in a single general direction. The interior flow passage of the heat transfer pipe may however be non-linear so as to extend in more than one general direction.

When the heat transfer pipe 203 is in use, the wall 301 defines a boundary between the closed environment within the electronics enclosure and the general surroundings; the interior fins 302 are external of the closed environment and exposed to the general atmosphere, and the exterior fins 303 extend into the closed environment within the electronics enclosure. The exterior fins 303 of the heat transfer pipe 203 assist in the transfer of waste heat within the internal environment of the electronics enclosure to the wall 301 and interior fins 302 of the heat transfer pipe 203. The surfaces of the wall 301 and the interior fins 302 of the heat transfer pipe 203 are used for heat exchange with the external environment, to effect cooling of the internal volume within the electronics enclosure.

As illustrated at A, the heat transfer pipe 203 allows cooling of the internal environment within the electronics enclosure by convective heat transfer using a flow of ambient air through the interior flow passage of the heat transfer pipe. Air enters the lower end 209 of the heat transfer pipe 203, flows upwards through the interior flow passage of the heat transfer pipe 203 and is then exhausted at a higher temperature through the upper end 208 of the heat transfer pipe 203. In addition, as illustrated at B, the heat transfer pipe 203 allows cooling of the internal environment within the electronics enclosure by convective heat transfer using precipitation through the interior flow passage of the heat transfer pipe. Water enters the upper end 208 of the heat transfer pipe 203, flows downwards through the interior flow passage of the heat transfer pipe 203 and exits at a higher temperature through the lower end 209 end of the heat transfer pipe 203. Cooling can be achieved through natural convection, with a greater magnitude of cooling achievable in conditions or wind and/or rain.

With reference to Figures 2 & 3, it can be seen that the cooling apparatus 202 comprising at least one heat transfer pipe 203 advantageously utilises the volume of waste space 106 within the remote radio head 201 such that additional cooling is provided without adding to the overall dimensions of the electronics enclosure unit. This feature is important in applications in which an electronics enclosure must be dimensioned to fit within a fixed envelope. Further, the heat transfer pipe is electrically passive, which advantageously avoids the requirement to electrically power the additional cooling apparatus and also overcomes issues of unreliability associated with electrically powered apparatus. Also, the construction of the heat transfer pipe is such that the addition of weight to the electronics enclosure in which the heat transfer pipe is installed is beneficially minimised. Yet further, the heat transfer pipe does not utilise any components that would generate undesirable noise.

A heat transfer pipe of cooling apparatus for an electronics enclosure as described herein may be fabricated from any suitable material or materials. In a preferred embodiment, each heat transfer pipe is fabricated from aluminium. Desirable characteristics of this material include good thermal conductivity, for effecting cooling of the electronics enclosure, and low weight, for minimising weight addition to the electronics enclosure. In an alternative embodiment, each heat transfer pipe is fabricated from graphite; this material also has desirable thermal conductivity properties.

A heat transfer pipe of cooling apparatus for an electronics enclosure as described herein may have any suitable internal and/or external coating or finish. For example, surfaces of the heat transfer pipe that are exposed to the general environment may advantageously be provided with a self-cleaning coating. As another example, surfaces of the heat transfer pipe may be provided with a black carbon coating to enhance additional cooling by thermal radiation.

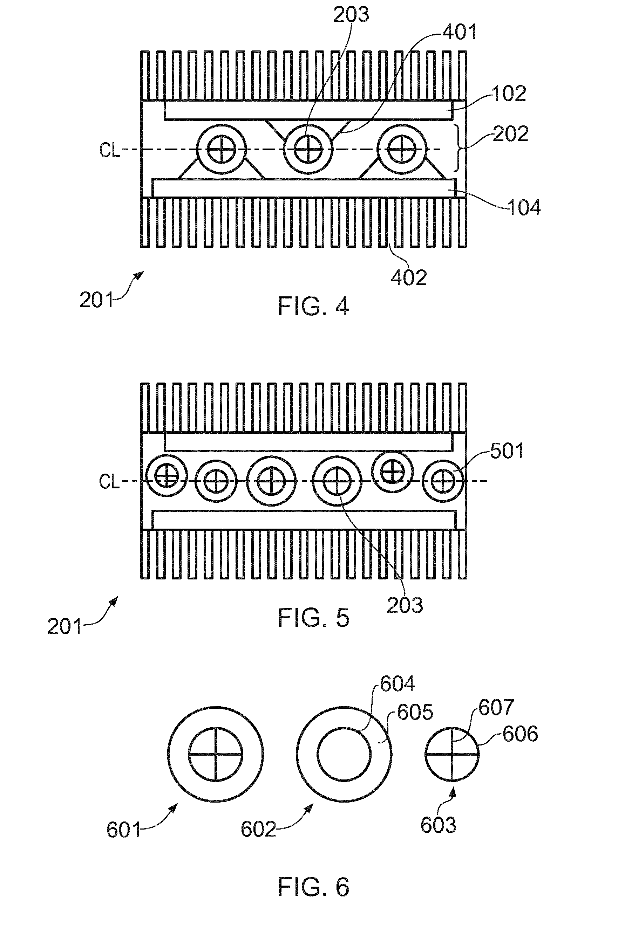

The cooling apparatus 202 may comprise at one connecting element that directly connects heat-generating equipment within the electronics enclosure 201 to at least one heat transfer pipe 203 of the cooling apparatus 202. In the arrangement shown in Figure 4, at least one connecting element 401 is provided that extends between a heat transfer pipe 203 of the cooling apparatus 202 and the first electronics equipment 102 within the electronics enclosure 201, and at least one connecting element 402 is provided that extends between a heat transfer pipe 203 of the cooling apparatus 202 and the second electronics equipment 104 within the electronics enclosure 201. The connecting elements 401, 402 of the cooling apparatus 202 serve to facilitate the transfer of heat away from the hot equipment to a heat transfer pipe 203 and, in turn, away from the interior of the electronics enclosure 201 to the outside environment.

A connecting element of cooling apparatus for an electronics enclosure as described herein may be fabricated from any suitable material or materials. In an embodiment, each connecting element is fabricated from copper; this material provides an interface with high thermal conductivity.

Using the cooling apparatus described herein, internal waste heat is either conducted or naturally convected to the heat transfer pipe, which exchanges heat to the atmosphere to reduce the temperature inside the electronics enclosure. The cooling apparatus 202 may comprise different types and/or sizes of heat transfer pipe. In the example illustrated in Figure 5, the cooling apparatus 202 of electronics enclosure 201 comprises at least one heat transfer pipe 203 having first dimensions and at least one heat transfer pipe 501 having second dimensions that are different from the first diameter of the first dimensions. The specific arrangement shown in Figure 5 comprises a plurality of heat transfer pipes 203 having a first diameter and a plurality of heat transfer pipes 501 having a second diameter that is small than the first diameter.

In an example, an electronics enclosure having approximate dimensions of 500mm x 250 mm x 250mm may accommodate one or more heat transfer pipes having a substantially circular cross-sectional shape with approximate dimensions of 20mm internal diameter and 40mm external diameter.

The size of a heat transfer pipe may vary between examples, according to the magnitude of additional cooling desired for a particular electronics enclosure. The type and density of interior and exterior fins of a heat transfer pipe as described herein may also vary between examples, depending on the level of cooling desired for a particular electronics enclosure.

A plurality of heat transfer pipes of cooling apparatus for use in cooling an electronics enclosure as described herein may be uniformly or non-uniformly spaced and/or aligned relative to a line through the electronics enclosure, such as a centre-line. For example, in the heat transfer pipe arrangement illustrated in Figure 4, the heat transfer pipes 203 are uniformly spaced and uniformly aligned along line CL; however, in the heat transfer pipe arrangement illustrated in Figure 5, the heat transfer pipes 203 and 501 are not so regularly disposed within the electronics enclosure.

The arrangement of a plurality of heat transfer pipes of cooling apparatus for use in cooling an electronics enclosure as described herein may vary, to accommodate different internal arrangements of equipment sealed within different electronics enclosures. The additional cooling enabled by the cooling apparatus described herein allows, in some circumstances, for lower temperature rated cabling or other componentry to be used with an electronics enclosure, with an associated cost-saving.

A heat transfer pipe for use in cooling an electronics enclosure as described herein may have one or more removable parts. Figure 6 shows a heat transfer pipe 601 comprising an outer part 602 and an inner part 603. The outer part 602 of the heat transfer pipe 601 comprises a wall 604 defining an interior flow passage therethrough, and a plurality of exterior fins 605 along the wall 604. The inner part 603 of the heat transfer pipe 601 comprises a wall 606 defining an interior passage therethrough, and a plurality of interior fins 607 along the wall 606. The inner part 603 is locatable within, and removable from, the outer part 602 of the heat transfer pipe 601. In the embodiment illustrated in Figure 6, the internal fins 606 of the heat transfer pipe 601 are therefore carried on a structure that is removable from the interior flow passage of the heat transfer pipe 601. By enabling the interior fins to be selectively removed, cleaning of the heat transfer pipe is facilitated. Further, the interior fin arrangement of the heat transfer pipe may be changed, by replacing the inner part with a different inner part having a different arrangement and/or number of interior fins.

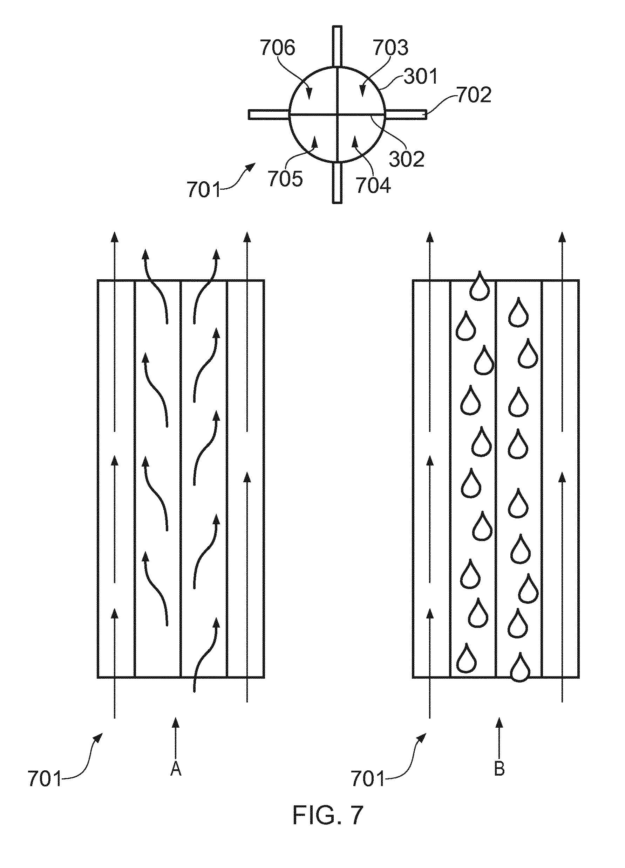

Figure 7 shows a heat transfer pipe 701 comprising a wall 301 defining an interior flow passage therethrough, a plurality of longitudinal interior fins 302 within the interior flow passage, and a plurality of exterior fins 702 along the wall 301. According to this illustrated embodiment, however, the exterior fins 702 of the heat transfer pipe 701 are longitudinal fins. In the shown arrangement, the exterior fins 702 are uniformly spaced around the perimeter of the wall 301 of the heat transfer pipe 701. Any suitable number of the longitudinal exterior fins may be provided, and may vary between examples.

As illustrated at A, the heat transfer pipe 701 allows cooling of the internal environment within the electronics enclosure by convective heat transfer using a flow of air through the interior flow passage of the heat transfer pipe, and as illustrated at B, the heat transfer pipe 701 allows cooling of the internal environment within the electronics enclosure by convective heat transfer using a flow of rain water through the interior flow passage of the heat transfer pipe. Thus, in a similar way to that of heat transfer pipe 203 shown in Figure 3, the heat transfer pipe 701 shown in this Figure provides additional cooling for an electronics enclosure by a flow of a fluid (whether as a gas and/or as a liquid) therethrough.

In this illustrated example, the interior fins 302 of the heat transfer pipe 701 are arranged to divide the interior flow passage into a plurality of passageways 703, 704, 705, 706. In the shown arrangement, the interior fins 302 divide the circular cross-section of the interior flow passage of the heat transfer pipe 701 into equally sized sectors. It is to be appreciated however that any suitable arrangement for defining a plurality of individual passageways within the interior flow passage of the heat transfer pipe may be utilised.

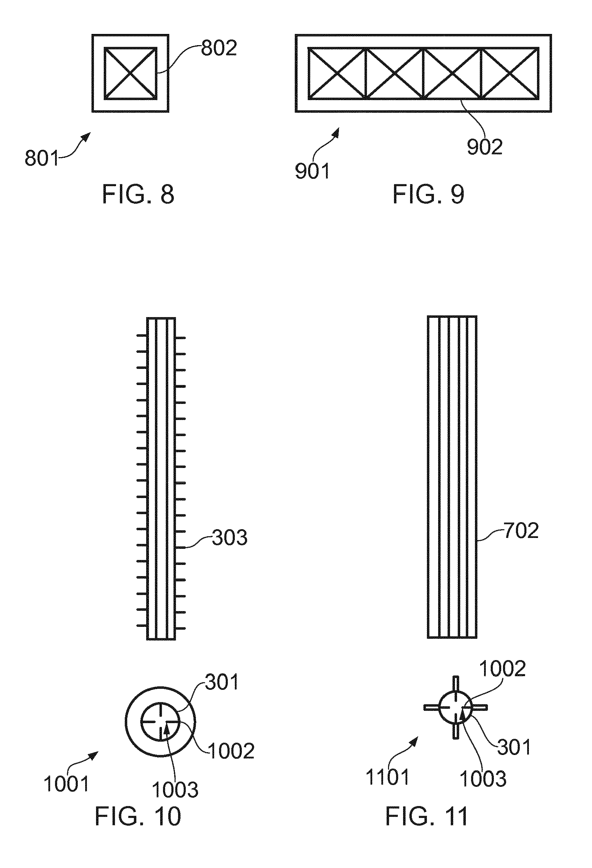

Figures 8 & 9 each show a heat transfer pipe comprising a substantially rectangular cross-sectional shape. Figure 8 shows a heat transfer pipe 801 comprising a wall 802 defining an interior flow passage having a substantially square cross-sectional shape, and Figure 9 shows a heat transfer pipe 901 comprising a wall 902 defining an interior flow passage having a substantially comprising a substantially non-square cross-sectional shape. In an example, the heat transfer pipe is so elongate as to extend substantially across the length of the waste volume within the electronics enclosure.

Figures 10 & 11 each show a heat transfer pipe comprising an arrangement of internal fins that do not intersect to form individual passageways, but instead form internal partitions. The heat transfer pipes 1001, 1101 of Figure 10 and Figure 11 respectively each comprise a wall 301 defining an interior flow passage therethrough, a plurality of longitudinal interior fins 1002 within the interior flow passage, and which extend inwardly from the internal surface of the wall 301 and present a free end 1003 but the heat transfer pipe 1001 of Figure 10 comprises a plurality of exterior radial fins 303 extending outwardly from the external surface of the wall 301 and the heat transfer pipe 1101 of Figure 11 comprises a plurality of exterior longitudinal fins 702 extending outwardly from the external surface of the wall 301.

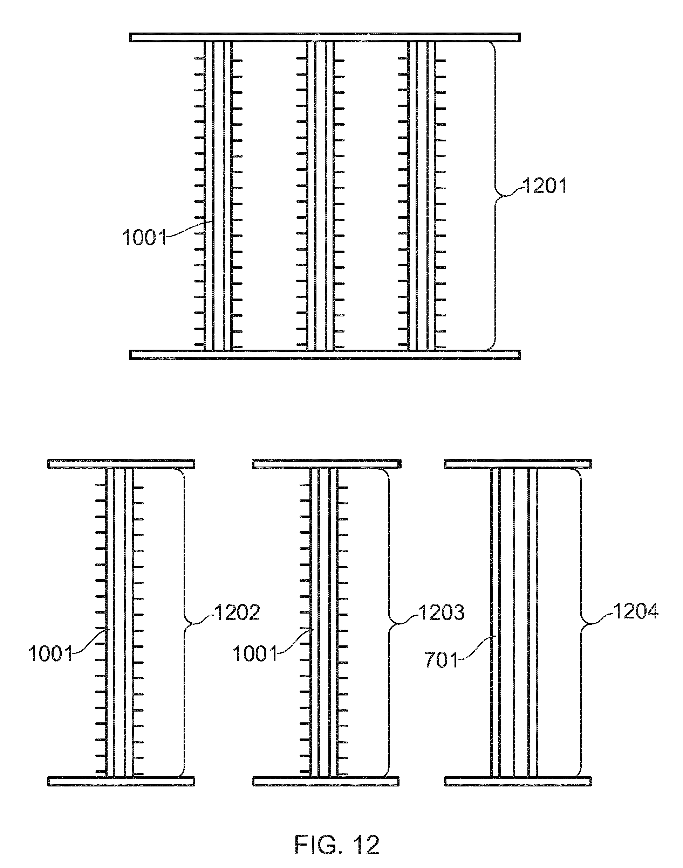

The cooling apparatus for use in cooling an electronics enclosure may comprise an installation frame that is arranged to the located with an electronics enclosure, and that supports one or more heat transfer pipes. The installation frame facilitates installation of the one or more heat transfer pipes within an electronics enclosure. A plurality of heat transfer pipes 1001 supported by an installation frame 1201 that is locatable within an electronics enclosure is illustrated in Figure 12. The use of the installation frame 1201 ensures that the heat transfer pipes 1001 are disposed within the waste volume inside the electronics enclosure to be provided with additional cooling in a predetermined relative arrangement. In the application of a remote radio head as described with reference to Figure 1, an installation frame supporting one or more heat transfer pipes may be provided around which the pair of half-shell elements can be fitted, with the top and bottom weatherised seals, to form the hermetically sealed internal chamber of the electronics enclosure. An installation frame may have any suitable construction and may be fabricated from any suitable material or materials.

Cooling apparatus for use in cooling an electronics enclosure may comprise one or more installation frames, each supporting one or more heat transfer pipes, for use within an electronics enclosure. The cooling apparatus may comprise a plurality of installation frame for use with the same electronics enclosure. A heat transfer pipe supported by one of the plurality of installation frames may be the same as or vary in one or more aspects from another heat transfer pipe supported by that installation frame or another of the plurality of installation frames. An example is shown in this Figure in which the cooling apparatus comprises three installation frames 1202, 1203, 1204 for use within the same electronics enclosure, with two of the installation frames 1202, 1203 supporting the same heat transfer pipe 1001 and with the other installation frames 1204 supporting a different heat transfer pipe 701.

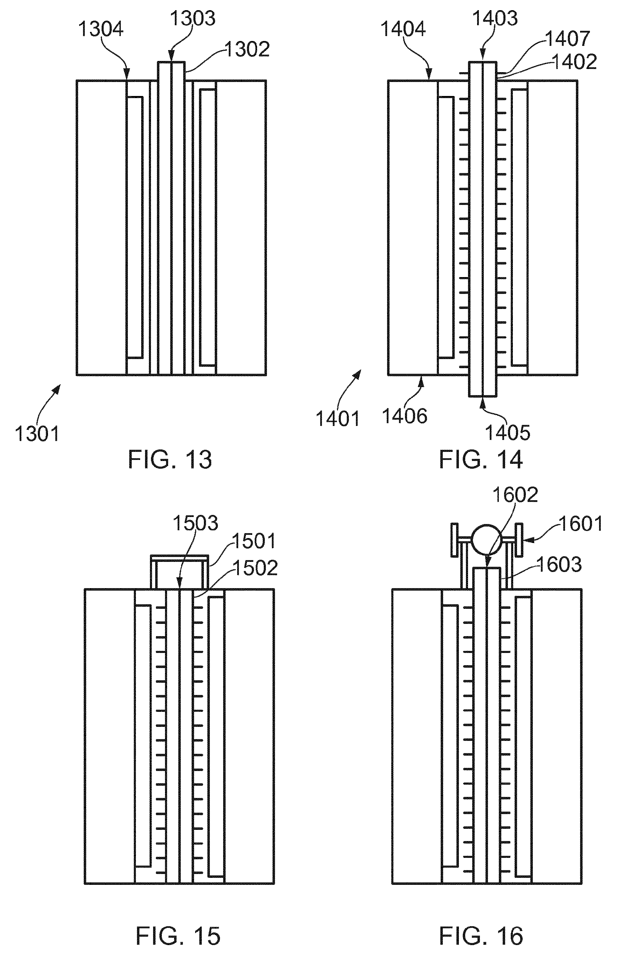

An electronics enclosure may be provided with a heat transfer pipe that projects therefrom to present at least one open end that is disposed outwardly from an external surface thereof. In the arrangements of Figures 13 & 14, the heat transfer pipe has at least one open end that is not substantially flush with the external walls of the electronics enclosure. In the arrangement illustrated in Figure 13, an electronics enclosure 1301 is provided with a heat transfer pipe 1302 having an upper open end 1303 that is located above the top surface of the electronics enclosure 1301. In the arrangement shown in Figure 14, an electronics enclosure 1401 has a heat transfer pipe 1402 that extends upwardly through the electronics enclosure 1401 such that the upper open end 1403 is higher than the top surface 1404 of this Figure, the electronics enclosure 1401, and the lower open end 1405 is lower than the bottom surface 1406 of the electronics enclosure 1401. In addition, in the arrangement shown in Figure 14, at least one exterior fin 1407 is provided along the length of the heat transfer pipe 1402 that is between the top surface 1404 of the electronics enclosure 1401 and the upper open end 1403 of the heat transfer pipe 1402. Thus, in the example of this Figure, exterior fins of a heat transfer pipe are positioned within, and outside of, the internal chamber of the electronics enclosure. The length of the heat transfer pipe that projects from the electronics enclosure unit may be provided with a coating that provides a visual indication that the heat transfer pipe is too hot for an operative to touch, to protect an operative working by the unit.

The cooling apparatus for an electronics enclosure as described herein may comprise further features. As illustrated in Figure 15, the cooling apparatus may comprise a mesh guard 1501 locatable over an open end of a heat transfer pipe. In the shown arrangement, the mesh guard is positioned to cover the upper open end 1503 of heat transfer pipe 1502, to prevent undesired ingress of matter, for example leaves or litter, that could lead to a blockage within the heat transfer pipe 1502. The cooling apparatus may comprise apparatus for enhancing air flow through a heat transfer pipe. In the arrangement shown in Figure 16, wind cups 1601 are located over the upper open end 1602 of heat transfer pipe 1603. In an example, cowling may be provided. Further potential features include the use of port-control apparatus to vary the size of an opening, which may be used to control the level of cooling dynamically.

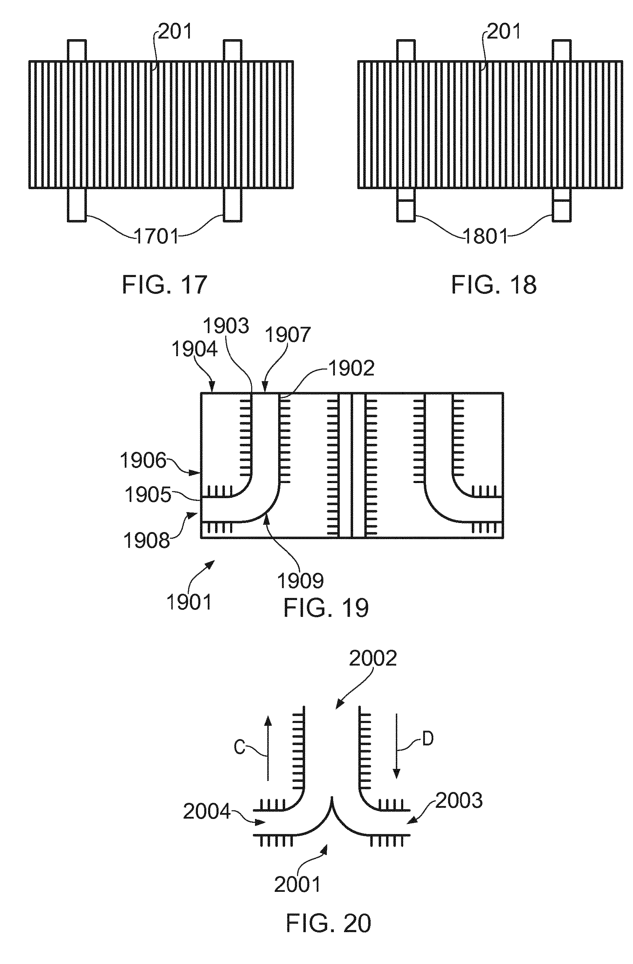

An electronics enclosure in the form a remote radio head is mounted with the bottom surface above ground. As shown in Figure 17, bracketry 1701 may be used to mount electronics enclosure 201 at height, for example to pole or a wall. Alternatively, as shown in Figure 18, a free-standing support structure 1801 may be used to self-support electronics enclosure 201 at height, at a suitable location.

An alternative type of electronics enclosure is ground-mounted, for example a ground-mounted cabinet. Figure 19 shows a schematic of a ground-mounted electronics enclosure 1901 comprising cooling apparatus according to the present invention. In this illustrated embodiment, the electronics enclosure 1901 comprises at least one heat transfer pipe 1902 so located within the electronics enclosure 1901 as to extend between a first opening 1903 in a top surface 1904 of the electronics enclosure 1901 and a second opening 1905 in a second, lower surface 1906 of the electronics enclosure 1901, and to present first and second ends 1907, 1908 respectively that are open to the atmosphere. In this embodiment, the second opening 1905 is in a side surface of the electronics enclosure 1901. In this embodiment also, the interior flow passage of the heat transfer pipe 1902 extend in more than one general direction due to a bend 1909 along the length of the heat transfer pipe 1902. In an example, the heat transfer pipe has a substantially curvilinear interior flow passage.

The heat transfer pipes 203, 701 shown in Figures 3 and 7 each define an interior flow passage with a pair of open ends. Considering flow in a single direction through each of the heat transfer pipes 203, 701, as shown at A and B of Figures 3 and 7, the interior flow passage of each of the heat transfer pipes 203, 701 has a single inlet and a single outlet, and is therefore a 'one-to-one' interior flow passageway. However, a heat transfer pipe as described herein may define an interior flow passage with more than two open ends, and may therefore be a 'one-to-many', a 'many-to-one' or a 'many-to-many' interior flow passageway depending on the number of inlets and outlets when considering a particular direction of flow between the top surface and a lower surface of the electronics enclosure. A heat transfer pipe 2001 according to the present invention is shown in Figure 20. The heat transfer pipe 2001 has first, second and third openings 2002, 2003, 2004 respectively. When considering flow through the heat transfer pipe 2001 in the direction indicated by arrow C, the interior flow passage is 'many-to-one', with two inlets and one outlet, but when considering flow through the heat transfer pipe 2001 in the opposite direction indicated by arrow D, the interior flow passage is 'one-to-many, with one inlet and two outlets.

A heat transfer pipe for use in cooling an electronics enclosure is hence provided. The heat transfer pipe comprises a wall defining an interior flow passage therethrough between first and second open ends, a plurality of interior fins within the interior flow passage, and a plurality of exterior fins along the wall. In use as described, the heat transfer pipe acts to lower the internal temperature of electronics within the electronics enclosure. This serves to increase the operational reliability and working life of componentry within the electronics enclosure, without utilising apparatus that uses additional power or uses components that result in a maintenance burden. An electronics enclosure comprising cooling apparatus, the cooling apparatus comprising at least one heat transfer pipe is also provided. Typically, the heat transfer pipe (s) will be incorporated during original construction of the electronics enclosure. A method of providing an electronics enclosure with cooling apparatus is further provided. A heat transfer pipe comprising a wall defining an interior flow passage therethrough between first and second open ends, a plurality of interior fins within the interior flow passage, and a plurality of exterior fins along the wall is received, and located within the electronics enclosure between a first opening in an upper surface thereof and a second opening in a lower surface thereof, with upper and lower ends of the interior flow passage open to the atmosphere.

Although illustrative embodiments of the invention have been disclosed in detail herein, with reference to the accompanying drawings, it is understood that the invention is not limited to the precise embodiments shown and that various changes and modifications can be effected therein by one skilled in the art without departing from the scope of the invention as defined by the appended claims and their equivalents.

## Claims

1. An electronics enclosure (201) comprising cooling apparatus (202), said cooling apparatus (202) comprising:
at least one heat transfer pipe (203),
each said heat transfer pipe (203) so located within the electronics enclosure (201) as to extend between a first opening (204) in a top surface (205) of the electronics enclosure (201) and a second opening (206) in a second lower surface (207) of the electronics enclosure (201), and to present first and second ends (208, 209) open to the atmosphere, and
each said heat transfer pipe (203) comprising a wall (301) defining an interior flow passage therethrough between said first and second open ends (208, 209), a plurality of longitudinal interior fins (302) within said interior flow passage, and a plurality of exterior fins (303) along said wall (301).

2. An electronics enclosure (201) as claimed in claimed 1, wherein said second opening is in one of: a bottom surface of the electronics enclosure, a side surface of the electronics enclosure.

3. An electronics enclosure (201) as claimed in claimed 1 or claim 2, wherein said first and second ends of said heat transfer pipe are substantially flush with the outer surfaces of the electronic enclosure.

4. An electronics enclosure (201) as claimed in any of claims 1 to 3, wherein at least one connecting element is provided that connects between heat emitting equipment (102, 104) within the electronics enclosure (201) and a heat transfer pipe(203) of the cooling apparatus (202).

5. An electronics enclosure (201) as claimed in any of claims 1 to 4, comprising a plurality of said heat transfer pipes (203).

6. An electronics enclosure (201) as claimed in any of claims 1 to 5, wherein said electronics enclosure (201) is one of: bracket mounted, ground mounted.

7. An electronics enclosure (201) as claimed in any of claims 1 to 6, wherein said electronics enclosure (201) is a remote radio head.

8. A heat transfer pipe (203) for use in cooling an electronics enclosure (201),
said heat transfer pipe (203) so installable within the electronics enclosure (201) as to extend between a first opening (204) in a top surface (205) of the electronics enclosure (201) and a second opening (206) in a second lower surface (207) the electronics enclosure (201), and
each said heat transfer pipe (203) comprising a wall (301) defining an interior flow passage therethrough, a plurality of longitudinal interior fins (302) within said interior flow passage, and a plurality of exterior fins (303) along said wall (301).

9. A heat transfer pipe (203) as claimed in claim 8, wherein said exterior fins (303) are one of: radial fins, longitudinal fins.

10. A heat transfer pipe (203) as claimed in claim 8 or claim 9, wherein said interior flow passage is one of: substantially linear, substantially curvilinear.

11. A heat transfer pipe (203) as claimed in any of claims 8 to 10, comprising at least one of: a substantially circular cross-sectional shape, a substantially rectangular cross-sectional shape.

12. A heat transfer pipe (203) as claimed in any of claims 8 to 11, wherein said internal fins (302) are arranged to divide said interior flow passage into a plurality of passageways.

13. A heat transfer pipe (601) as claimed in any of claims 8 to 12, wherein said internal fins (606) are carried on a structure (603) that is removable from said interior flow passage.

14. A heat transfer pipe (203) as claimed in any in of claims 8 to 13, supported by an installation frame (1201) that is locatable within the electronics enclosure (201).

15. A method of providing an electronics enclosure (201) with cooling apparatus (202), comprising the steps of:
a) receiving a heat transfer pipe (203) comprising a wall (301) defining an interior flow passage therethrough between first and second open ends (208, 209), a plurality of longitudinal interior fins (302) within said interior flow passage, and a plurality of exterior fins (303) along said wall (301), and
b) locating said received heat transfer pipe (203) within said electronics enclosure (201) such that said heat transfer pipe (203) extends between a first opening in an upper surface of the electronics enclosure (201) and a second opening in a second lower surface of the electronics enclosure (201), with upper and lower ends (208, 209) of said interior flow passage open to the atmosphere.
